(19) Europäisches Patentamt
European Patent Office
Office européen des brevets

(11) **EP 2 974 302 B1**

(12) **EUROPEAN PATENT SPECIFICATION**

(45) Date of publication and mention
of the grant of the patent:
**01.05.2019 Bulletin 2019/18**

(51) Int Cl.:
***H04N 13/20*** *(2018.01)*

(21) Application number: **14768046.6**

(22) Date of filing: **12.03.2014**

(86) International application number:
**PCT/US2014/024964**

(87) International publication number:
**WO 2014/151093 (25.09.2014 Gazette 2014/39)**

(54) **THREE DIMENSIONAL IMAGING UTILIZING STACKED IMAGER DEVICES AND ASSOCIATED METHODS**

DREIDIMENSIONALE BILDGEBUNG MIT GESTAPELTEN BILDGEBERELEMENTEN UND ASSOZIIERTE VERFAHREN

IMAGERIE TRIDIMENSIONNELLE UTILISANT DES DISPOSITIFS IMAGEURS EMPILÉS ET PROCÉDÉS ASSOCIÉS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.03.2013 US 201361798805 P**

(43) Date of publication of application:
**20.01.2016 Bulletin 2016/03**

(73) Proprietors:
• **SiOnyx, LLC**
**Beverly, MA 01915-6506 (US)**
• **Haddad, Homayoon**
**Beaverton, Oregon 97007 (US)**
• **Feng, Chen**
**Snohomish, Washington 98296 (US)**
• **Forbes, Leonard**
**Corvallis, Oregon 97330 (US)**

(72) Inventors:
• **HADDAD, Homayoon**
**Beaverton, Oregon 97007 (US)**
• **FENG, Chen**
**Snohomish, Washington 98296 (US)**
• **FORBES, Leonard**
**Corvallis, Oregon 97330 (US)**

(74) Representative: **Walker, Ross Thomson**
**Forresters IP LLP**
**Skygarden**
**Erika-Mann-Strasse 11**
**80636 München (DE)**

(56) References cited:
**EP-A1- 2 509 107      WO-A1-2012/174752**
**WO-A2-2014/110484    US-A1- 2010 038 542**
**US-A1- 2011 227 138    US-A1- 2012 300 037**

• **ZION D ET AL: "Depth from defocus using the hermite transform", IMAGE PROCESSING, 1998. ICIP 98. PROCEEDINGS. 1998 INTERNATIONAL CONFERENCE ON CHICAGO, IL, USA 4-7 OCT. 1998, LOS ALAMITOS, CA, USA,IEEE COMPUT. SOC, US, vol. 2, 4 October 1998 (1998-10-04), pages 958-962, XP010308678, DOI: 10.1109/ICIP.1998.723713 ISBN: 978-0-8186-8821-8**
• **XIONG Y ET AL: "Depth from focusing and defocusing", COMPUTER VISION AND PATTERN RECOGNITION, 1993. PROCEEDINGS CVPR '93., 1993 IEEE COMPUTER SOCIETY CONFERENCE ON NEW YORK, NY, USA 15-17 JUNE, LOS ALAMITOS, CA, USA,IEEE COMPUT. SOC, 15 June 1993 (1993-06-15), pages 68-73, XP010095843, DOI: 10.1109/CVPR.1993.340977 ISBN: 978-0-8186-3880-0**

**Description**

**BACKGROUND**

Active pixel sensors (APS) are image sensors including integrated circuit containing an array of pixel sensors, each pixel containing a photodetector and an active amplifier. Such an image sensor is typically produced by a complementary metal-oxide-semiconductor (CMOS) process. CMOS APS can be used in web cams, high speed and motion capture cameras, digital radiography, endoscopy cameras, DSLRs, cell phone cameras, and the like. Other advances in image sensor technology have been implemented, such as the use of an intra-pixel charge transfer along with an in-pixel amplifier to achieve true correlated double sampling (CDS) and low temporal noise operation, and on-chip circuits for fixed-pattern noise reduction.

Some CMOS APS imagers have utilized backside illuminated (BSI) technology. BSI imager technology includes a semiconductor wafer bonded to a permanent carrier on the front side and then thinned from the backside. Passivation layers, anti-reflecting layers, color filters and micro-lens can be positioned on the backside, and the resulting device can be backside illuminated. Through-Silicon Vias (TSV) can be used to provide electrical connections from the front side to backside output pads. BSI CMOS APS imagers are becoming useful technology for many types of visible imagers in cell phones and digital cameras.

More generally, electromagnetic radiation can be present across a broad wavelength range, including visible range wavelengths (approximately 350nm to 800nm) and non-visible wavelengths (longer than about 800nm or shorter than 350 nm). The infrared spectrum is often described as including a near infrared portion of the spectrum including wavelengths of approximately 800 to 1300nm, a short wave infrared portion of the spectrum including wavelengths of approximately 1300nm to 3 micrometers, and a mid to long range wave infrared (or thermal infrared) portion of the spectrum including wavelengths greater than about 3 micrometers up to about 20 micrometers. These are generally and collectively referred to herein as infrared portions of the electromagnetic spectrum unless otherwise noted.

Traditional silicon photodetecting imagers have limited light absorption/detection properties. For example, such silicon based detectors are mostly transparent to infrared light. While other mostly opaque materials (e.g. InGaAs) can be used to detect infrared electromagnetic radiation having wavelengths greater that about 1000nm, silicon is still commonly used because it is relatively cheap to manufacture and can be used to detect wavelengths in the visible spectrum (i.e. visible light, 350 nm - 800 nm). Traditional silicon materials require substantial path lengths and absorption depths to detect photons having wavelengths longer than approximately 700 nm. While visible light can be absorbed at relatively shallow depths in silicon, absorption of longer wavelengths (e.g. 900 nm) in silicon of a standard wafer depth (e.g. approximately $750\mu$m) is poor if at all.

International publication number WO2012/174752A1 discloses a conventional multi-depth-of-field light-sensing device, a system, a depth of field extension method and an optical imaging system.

SUMMARY

According to the present invention, there is provided an imaging system as defined in claim 1 hereinafter.

The present disclosure provides various systems and devices having a unique architecture that can determine distance and generate three dimensional representations of a subject, including associated methods thereof. In one aspect, for example, an imaging system capable of deriving three dimensional information from a three dimensional subject is provided. Such a system can include a first imager array having a first light incident surface and a second imager array having a second light incident surface. The second imager array can be coupled to the first imager array at a surface that is opposite the first light incident surface, with the second light incident surface being oriented toward the first imager array and at least substantially uniformly spaced at a distance of from about 2 microns to about 150 microns from the first light incident surface. The system can also include a system lens positioned to direct incident light along an optical pathway onto the first light incident surface of the first imager. The first imager array is operable to detect a first portion of the light passing along the optical pathway and to pass through a second portion of the light, where the second imager array is operable to detect at least a part of the second portion of light. In one aspect, the first imager and the second imager are detecting and comparing light having substantially the same wavelength in order to calculate distance to a subject or to generate a three dimensional representation of the subject. Regarding the frequencies of light that can be utilized by the present imager arrays, the first portion of light and the second portion of light can have at least one wavelength of from about 500 nm to about 1100 nm. In another aspect, the first portion of light and the second portion of light can have at least one wavelength of from about 750 nm to about 1100 nm. Additionally, in some aspects such a system can further include an active light emitter configured to emit active light radiation at least substantially toward the three dimensional subject, where the active light radiation has a center wavelength of from about 750 nm to about 1100 nm. In another aspect, the active light radiation has a center frequency of 850 nm, 940 nm, or 1064 nm.

In another aspect, the system can also include a computation module operable to calculate distance data from the imaging system to the three dimensional subject using first image data collected by the first imager array from the first portion of light and second image data collected by the second imager array from the second portion of light. In another aspect, the computation module is operable to generate a three dimensional representation of the three dimensional subject from the distance data. Furthermore, in some aspects the imaging system can be incorporated into a computing system operable to alter computation based on variations in distance data derived from movements of a subject.

Additionally, a variety of system configurations are contemplated, which are considered to be non-limiting. In one aspect, the first imager array includes a plurality of pixels architecturally configured as front-side illuminated (FSI) pixels. In another aspect, the second imager array includes a plurality of pixels architecturally configured as FSI pixels or backside illuminated (BSI) pixels.

Furthermore, various structures can be utilized to redirect or otherwise reflect light that passes through the system back into the system. In one aspect, a textured region can be coupled to the second imager array on a side opposite the first imager array, such that the textured region is positioned to redirect light passing through the second imager array back into the second imager array. In another aspect, the system can include a reflector coupled to the second imager array on a side opposite the first imager array, such that the reflector is positioned to reflect light passing through the second imager array back into the second imager array.

The present disclosure additionally provides a method of determining distance to a subject. Such a method can include focusing incident light along an optical pathway onto a first light incident surface of a first imaging array, wherein the first imaging array captures a first portion of the light having at least one wavelength of from about 500 nm to about 1100 nm to generate a first data set and passes through a second portion of the light along the optical pathway. The method can also include receiving the second portion of the light onto a second light incident surface of a second imaging array, wherein the second imaging array captures the second portion of the light having at least one wavelength of from about 500 nm to about 1100 nm to generate a second data set. In another aspect, the first portion of the light has at least one wavelength of from about 750 nm to about 1100 nm and the second portion of the light has at least one wavelength of from about 750 nm to about 1100 nm. Additionally, the distance to the subject can then be derived from variations between the first data set and the second data set. In some aspects, at least part of the second portion of light that passes through the second imaging array can be redirected back into the second imaging array.

The distance between the first imaging array and the second imaging array can vary depending on the wavelengths of light being utilized and the distances to which three dimensional detection is desired. In one aspect, however, the distance between the first light incident surface and the second light incident surface is from about 2 microns to about 150 microns.

In some aspects the method can further include emitting active light radiation toward the subject such that at least a portion of the incident light focused along the optical pathway includes the active light radiation. In one aspect, the active light radiation can be IR light radiation. In another aspect, the active light radiation can have a center frequency selected from 850 nm, 940 nm, and 1064 nm.

In yet another aspect the method can further include generating a three dimensional representation of the subject. In one specific aspect, generating the three dimensional representation can include determining a plurality of distances from the first light incident surface to a surface of the subject at a plurality of locations across the surface of the subject, and using the distances to generate the three dimensional representation.

## BRIEF DESCRIPTION OF THE DRAWINGS

For a fuller understanding of the nature and advantage of the present disclosure, reference is being made to the following detailed description of various embodiments and in connection with the accompanying drawings, in which:

FIG. 1 shows a cross sectional view of a stacked imager in accordance with an aspect of the present disclosure.
FIG. 2 shows a schematic diagram of the effects of changing distance to a subject on a stacked imager system in accordance with another aspect of the present disclosure.
FIG. 3A shows a schematic diagram of the effects of changing distance to a subject on a stacked imager system in accordance with another aspect of the present disclosure.
FIG. 3B shows a schematic diagram of the effects of changing distance to a subject on a stacked imager system in accordance with another aspect of the present disclosure.
FIG. 3C shows a schematic diagram of the effects of changing distance to a subject on a stacked imager system in accordance with another aspect of the present disclosure.
FIG. 4 shows a cross sectional view of a stacked imager system in accordance with an aspect of the present disclosure.
FIG. 5 shows a cross sectional view of a stacked imager system in accordance with an aspect of the present disclosure.

FIG. 6A shows a cross sectional view of various steps in the manufacture of a stacked imager in accordance with another aspect of the present disclosure.

FIG. 6B shows a cross sectional view of various steps in the manufacture of a stacked imager in accordance with another aspect of the present disclosure.

FIG. 6C shows a cross sectional view of various steps in the manufacture of a stacked imager in accordance with another aspect of the present disclosure.

FIG. 6D shows a cross sectional view of various steps in the manufacture of a stacked imager in accordance with another aspect of the present disclosure.

FIG. 6E shows a cross sectional view of various steps in the manufacture of a stacked imager in accordance with another aspect of the present disclosure.

FIG. 7A shows a cross sectional view of various steps in the manufacture of a stacked imager in accordance with another aspect of the present disclosure.

FIG. 7B shows a cross sectional view of various steps in the manufacture of a stacked imager in accordance with another aspect of the present disclosure.

FIG. 7C shows a cross sectional view of various steps in the manufacture of a stacked imager in accordance with another aspect of the present disclosure.

FIG. 7D shows a cross sectional view of various steps in the manufacture of a stacked imager in accordance with another aspect of the present disclosure.

FIG. 7E shows a cross sectional view of various steps in the manufacture of a stacked imager in accordance with another aspect of the present disclosure.

## DETAILED DESCRIPTION

Before the present disclosure is described herein, it is to be understood that this disclosure is not limited to the particular structures, process steps, or materials disclosed herein, but is extended to equivalents thereof as would be recognized by those ordinarily skilled in the relevant arts. It should also be understood that terminology employed herein is used for the purpose of describing particular embodiments only and is not intended to be limiting.

## Definitions

The following terminology will be used in accordance with the definitions set forth below.

It should be noted that, as used in this specification and the appended claims, the singular forms "a," and, "the" include plural referents unless the context clearly dictates otherwise. Thus, for example, reference to "a dopant" includes one or more of such dopants and reference to "the layer" includes reference to one or more of such layers.

As used herein, the terms "textured region" and "textured surface" can be used interchangeably, and refer to a surface having a topology with nano- to micron-sized surface variations formed by a texturing technique, a few examples of which are discussed herein. While the characteristics of such a surface can be variable depending on the materials and techniques employed, in one aspect such a surface can be several hundred nanometers thick and made up of nanocrystallites (e.g. from about 10 to about 50 nanometers) and nanopores. In another aspect, such a surface can include micron-sized structures (e.g. about 2 $\mu$m to about 10 $\mu$m). In yet another aspect, the surface can include nano-sized and/or micron-sized structures from about 5 nm and about 10 $\mu$m. In yet another aspect the surface features can be from about 100 nm to about 1 $\mu$m.

As used herein, the terms "surface modifying" and "surface modification" refer to the altering of a surface of a semiconductor material to form a textured surface using a variety of surface modification techniques. Non-limiting examples of such techniques include plasma etching, reactive ion etching, porous silicon etching, lasing, chemical etching (e.g. anisotropic etching, isotropic etching), nanoimprinting, material deposition, selective epitaxial growth, shallow trench isolation techniques, and the like, including combinations thereof.

As used herein, the term "subject" refers to any object, living or non-living, that has a three dimensional structure or that can be imaged to determine distance. Non-limiting examples can include humans, animals, vehicles, buildings and building structures such as doors, windows, and the like, plants, animal enclosures, geological structures, and the like.

As used herein, the term "backside illumination" (BSI) refers to a device architecture design whereby electromagnetic radiation is incident on a surface of a semiconductor material that is opposite a surface containing the device circuitry. In other words, electromagnetic radiation is incident upon and passes through a semiconductor material prior to contacting the device circuitry.

As used herein, the term "front side illumination" (FSI) refers to a device architecture design whereby electromagnetic radiation is incident on a surface of a semiconductor material containing the device circuitry. In some cases a lens can be used to focus incident light onto an active absorbing region of the device while reducing the amount of light that impinges the device circuitry.

As used herein, the term "light incident surface" refers to a surface of an active semiconductor layer in an imager that is first struck by light entering the imager. As such, other materials that make up an imager or a device containing an imager that are positioned between the incoming light and the active layer should not be considered to be light incident surfaces unless the context clearly indicates otherwise. In the case of multiple imagers stacked upon one another, each imager will have a light incident surface. Distances described herein between light incident surfaces of stacked imagers, for example, represent the distances between the active layer surfaces of each imager that is first struck by incident light on an initial pass through each imager.

In this application, "comprises," "comprising," "containing" and "having" and the like can have the meaning ascribed to them in U.S. Patent law and can mean "includes," "including," and the like, and are generally interpreted to be open ended terms. The terms "consisting of' or "consists of' are closed terms, and include only the components, structures, steps, or the like specifically listed in conjunction with such terms, as well as that which is in accordance with U.S. Patent law. "Consisting essentially of' or "consists essentially of' have the meaning generally ascribed to them by U.S. Patent law. In particular, such terms are generally closed terms, with the exception of allowing inclusion of additional items, materials, components, steps, or elements, that do not materially affect the basic and novel characteristics or function of the item(s) used in connection therewith. For example, trace elements present in a composition, but not affecting the composition's nature or characteristics would be permissible if present under the "consisting essentially of' language, even though not expressly recited in a list of items following such terminology. When using an open ended term, like "comprising" or "including," it is understood that direct support should be afforded also to "consisting essentially of' language as well as "consisting of' language as if stated explicitly, and vice versa. Further, it is to be understood that the listing of components, species, or the like in a group is done for the sake of convenience and that such groups should be interpreted not only in their entirety, but also as though each individual member of the group has been articulated separately and individually without the other members of the group unless the context dictates otherwise. This is true of groups contained both in the specification and claims of this application. Additionally, no individual member of a group should be construed as a de facto equivalent of any other member of the same group solely based on their presentation in a common group without indications to the contrary.

As used herein, the term "substantially" refers to the complete or nearly complete extent or degree of an action, characteristic, property, state, structure, item, or result. For example, an object that is "substantially" enclosed would mean that the object is either completely enclosed or nearly completely enclosed. The exact allowable degree of deviation from absolute completeness may in some cases depend on the specific context. However, generally speaking the nearness of completion will be so as to have the same overall result as if absolute and total completion were obtained. The use of "substantially" is equally applicable when used in a negative connotation to refer to the complete or near complete lack of an action, characteristic, property, state, structure, item, or result. For example, a composition that is "substantially free of' particles would either completely lack particles, or so nearly completely lack particles that the effect would be the same as if it completely lacked particles. In other words, a composition that is "substantially free of' an ingredient or element may still actually contain such item as long as there is no measurable effect thereof.

As used herein, the term "about" is used to provide flexibility to a numerical range endpoint by providing that a given value may be "a little above" or "a little below" the endpoint.

As used herein, a plurality of items, structural elements, compositional elements, and/or materials may be presented in a common list for convenience. However, these lists should be construed as though each member of the list is individually identified as a separate and unique member. Thus, no individual member of such list should be construed as a de facto equivalent of any other member of the same list solely based on their presentation in a common group without indications to the contrary.

Concentrations, amounts, and other numerical data may be expressed or presented herein in a range format. It is to be understood that such a range format is used merely for convenience and brevity and thus should be interpreted flexibly to include not only the numerical values explicitly recited as the limits of the range, but also to include all the individual numerical values or sub-ranges encompassed within that range as if each numerical value and sub-range is explicitly recited. As an illustration, a numerical range of "about 1 to about 5" should be interpreted to include not only the explicitly recited values of about 1 to about 5, but also include individual values and sub-ranges within the indicated range. Thus, included in this numerical range are individual values such as 2, 3, and 4 and sub-ranges such as from 1-3, from 2-4, and from 3-5, etc., as well as 1, 2, 3, 4, and 5, individually.

This same principle applies to ranges reciting only one numerical value as a minimum or a maximum. Furthermore, such an interpretation should apply regardless of the breadth of the range or the characteristics being described.

**The Disclosure**

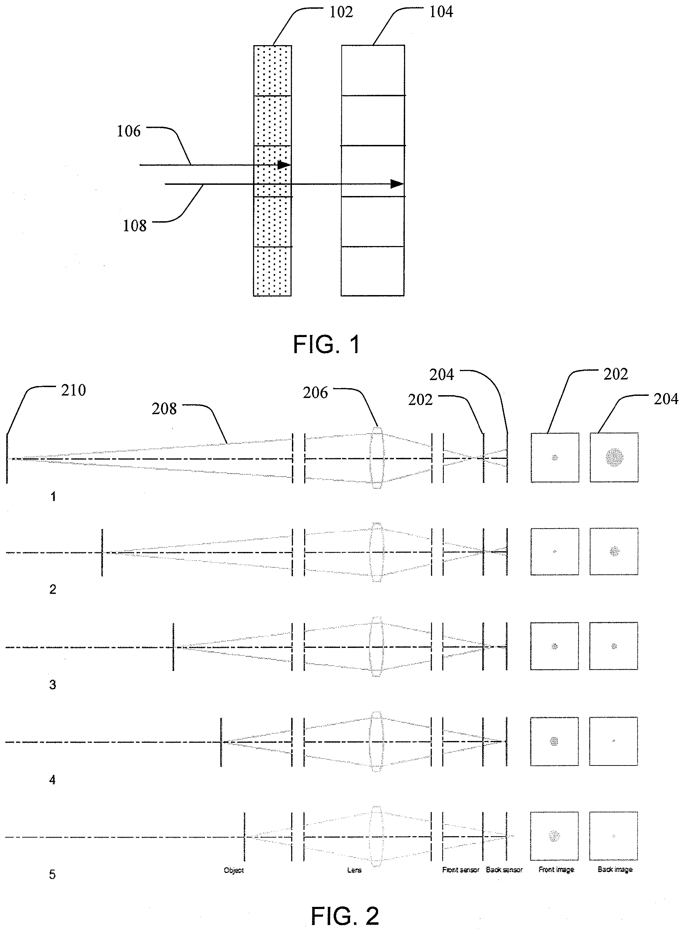

The present disclosure provides devices, systems, and methods for obtaining 3D information from an object. For example, in one aspect two imager arrays can be positioned in a stacked configurations along an optical axis, such that light passes through the first imager sensor having an array of pixels before contacting the second imager sensor having an array of pixels. Such an arrangement is shown schematically in FIG. 1. A first imager array 102 is positioned in a stacked configuration with a second imager array 104. The first imager array 102 captures a first portion of the incident light 106, while the second imager array 104 captures a second portion of the incident light 108 that passes through the first imaging array. It is noted that, while the portions of light are shown as distinct lines in FIG. 1 for clarity, these lines are intended to represent the portion of the overall incident light that is absorbed by each imager array. Thus, light from an object that is being imaged is captured on both imager arrays and will create different image patterns on each imager array that is a function of the distance from each imager array to the object. Differences in these image patterns can thus be utilized to obtain distance and/or 3D information about the object. In some cases a "light field" can be computed giving, for example, the light wavelength, intensity, and direction of light rays passing through the imager. Computations can then performed, in some cases in real time, by an on-chip processing unit or in a system processing unit to provide a variety of data, including visible image, IR image, range or distance to the object, 3D information, and the like. The object distance information collected can also be used to create a three dimensional image of the object.

FIG. 2 shows a side view schematic diagram of such three dimensional imaging at different distances, represented by rows 1-5. The imaging device can include a first imager array 202, a second imager array 204, and a system lens 206 for focusing incident light 208 onto the first and second imager arrays. A subject 210 is shown at a given distance for each of rows 1-5 from the imaging arrays. The boxes shown to the right of the imager arrays represent the imaging surface of each of the arrays, with the imaging surface for the first imaging array 202 being on the left and the imaging surface for the second imaging array 204 being on the right. The circle shown in each of the imaging surfaces represents the image patterns formed on each imaging surface of the subject 208 for a given distance. As is shown in FIG. 2, as the subject moves closer to the imager arrays, the dimensions of the image patterns on the imaging surfaces change as a function of the distance to each imager array. As such, the differences between the image patterns for a given distance can be utilized to calculate the distance to the subject. As the image pattern differences change, the change in distance to the subject can be repeatedly calculated. Furthermore, three dimensional representations can be obtained of subjects, including for subjects with complex surface contours or structures. In such cases, the three dimensional nature of a subject is reflected in the image pattern created on each of the imager arrays. The differences between image patterns from each array can be utilized to create a three dimensional representation. Such a representation can include three dimensional measurements of the subject, as well as three dimensional images.

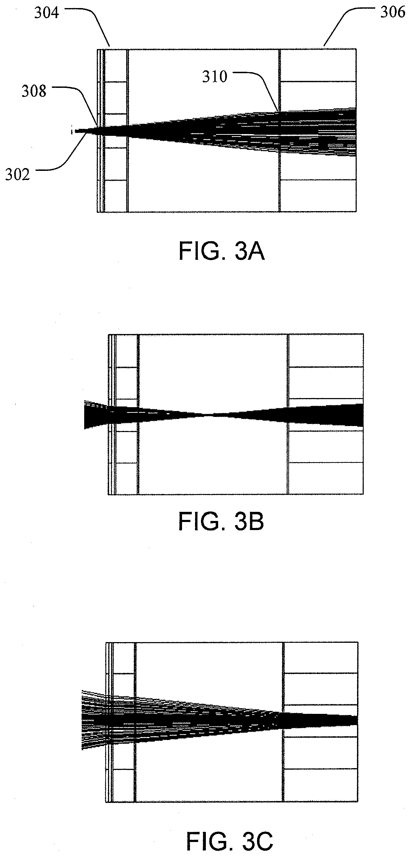

These concepts are further illustrated in FIGs. 3A-C where incident light 302 is shown passing through a first imager array 304 and a second imager array 306. The incident light 302 contacts the first imager array 304 with a first image pattern 308 that is related, at least in part, to the distance to the subject and the characteristics and distance of the system lens (not shown) from the first imager array 302. Due to the greater distance of the subject and the system lens from the second imager array 306, the second image pattern 310 is different from the first image pattern 308. For example, the patterns will often differ in size between the two arrays, and the pixels that detect the pattern will be different between the two imager arrays. It is noted, however, that in some limited situations the patterns on both imager arrays will be the same size. As the subject moves closer to the imager arrays (FIGs. 3B and 3C), the first and second image patterns concomitantly vary.

The following are exemplary descriptions of techniques that can be utilized to perform such stacked imager array calculations. It should be understood that these techniques are non-limiting, and that the scope of the present disclosure includes any technique for performing such calculations. Accordingly, the distance to a subject can be calculated based on the image feature difference between the first image pattern and the second image pattern of the stacked imager array, with known imager stack structure and system lens data.

In one aspect, distance to a subject with a point or near-point source as well as image features can be calculated directly. Such point or near-point sources will generally produce simple image patters on each imager array. First, the effective image pattern radii of the first image pattern and the second image pattern can be determined as r1 and r2, respectively. The effective feature radii of a defocussed image can be calculated from the total volume of the image pixel values according to Equations I and II:

$$r1 = sqrt(sum(pixel\_value\_image1)/(pi*max(pixel\_value\_image1) \qquad I$$

$$r2 = sqrt(sum(pixel\_value\_image2)/(pi*max(pixel\_value\_image2) \qquad II$$

where r1 and r2 are the image radii of the first image pattern and the second image pattern. Pixel values are in the sampling kernels of 5X5 to 10X10 pixels. Optically, with generic imaging system optics, focused images occur at a single plane with the best focal distance relative to the optics for specific subject. At this best focused location, the image is the sharpest with the smallest feature size for any image contents. At any other location, image will be defocused (a blurred image), with feature sizes that are bigger for the same image content at focused location.

Next, the smallest image size location from the first image based on the feature radii of the first image pattern and the second image pattern is calculated by Equation III:

$$d = r1*t/(r1+r2) \qquad III$$

where d is the distance from the first image, r1 and r2 are the effective feature radii of the first image and second image, and t is the separation between the first light incident surface and second light incident surface. The smallest image feature size location is at the best focus location, where image is focused with minimum blur. Depending on the design of the system, for some aspects including a mix of front side illuminated and back side illuminated imagers, an offset may be introduced to compensate for the difference in the distance from the front of the image array to the effective image plane.

The subject distance can then be calculated using the lens imaging Equation IV:

$$D = 1/(1/f - 1/(s+d)) \qquad IV$$

where D is the distance from the subject to the lens' principle plane, f is the focal length of the imaging lens, s is the distance from lens principle plane to the first image, and d is the distance from the first image to the smallest image location. In some aspects the actual distance calculation can consider the image stack layer material refractive index because the actual distance in the non-air material will be, according to Equation V:

$$(\text{Distance in material}) = (\text{distance in air}) * (\text{material refractive index}) \qquad V$$

Furthermore, the x and y position of an image feature in an imager array used in distance calculation can be calculated using a centroid, as is shown by Equations VI and VII:

$$xc = sum(x * (\text{pixel value})) / sum (\text{pixel value}) \qquad VI$$

$$yc = sum(y * (\text{pixel value})) / sum (\text{pixel value}) \qquad VII$$

It is noted that the centroid xc and yc position is not limited by the pixel resolution, as x and y are pixel coordinates. Sub-pixel result can be used to achieve required calculation precision. The precision of the position can be sensor signal-to-noise ratio limited.

For a non-point object source, image feature size can be determined by cross correlation between the inverse scaled first image and second image. First, the inverse scaled cross correlation is calculated according to Equation VIII:

$$C = sum ((\text{Inverse scaled first image pixel values}) * (\text{second image pixel value}))$$

$$VIII$$

where C is the result of the inverse scaled correlation. The inverse scaled first image is processed by applying the inverse scale factor k to the image size (similar to a digital zoom). Again, the scaling is not pixel resolution limited, and sub-pixel scaling process is used to find the best correlated scale factor k with the highest correction result C.

The best correlated scale factor k can then be used to describe the relationship between the first image and the second image. The image distance from the first image than can be calculated as according to Equation IX:

$$d = r1*t /(r1 + r2) = r1 *t /(r1 + k*r1) = t/(1+k) \qquad IX$$

where d is the image distance from first image to the smallest image size location, t is the separation between first light incident surface and second light incident surface, and k is the scale factor applied to the first image in cross correlation. Depending on the design of the system, for some aspects including a mix of front side illuminated and back side illuminated imagers, an offset may be introduced to compensate for the difference in the distance from the front of the image array to the effective image plane.

The distance to the subject can then be calculated according to Equation X:

$$D = 1/(1/f - 1/(s+d)) \qquad X$$

where D is the distance from the subject to the lens principle plane, f is the focal length of the imaging lens, s is the distance from lens principle plane to the first image, and d is the distance from first image to the smallest image location. Again, compensation can be made for the refractive index of the imager array material.

A variety of configurations are contemplated for carrying out the calculations utilized to derive distance and/or three dimensional information from a subject. For example, in one aspect the calculations or at least a portion of the calculations can be performed on-chip with the imager arrays. In another aspect, a dedicated image processing unit can be utilized for the calculations or at least a portion of the calculations. In other aspects, the calculations or at least a portion of the calculations can be performed in a computing device.

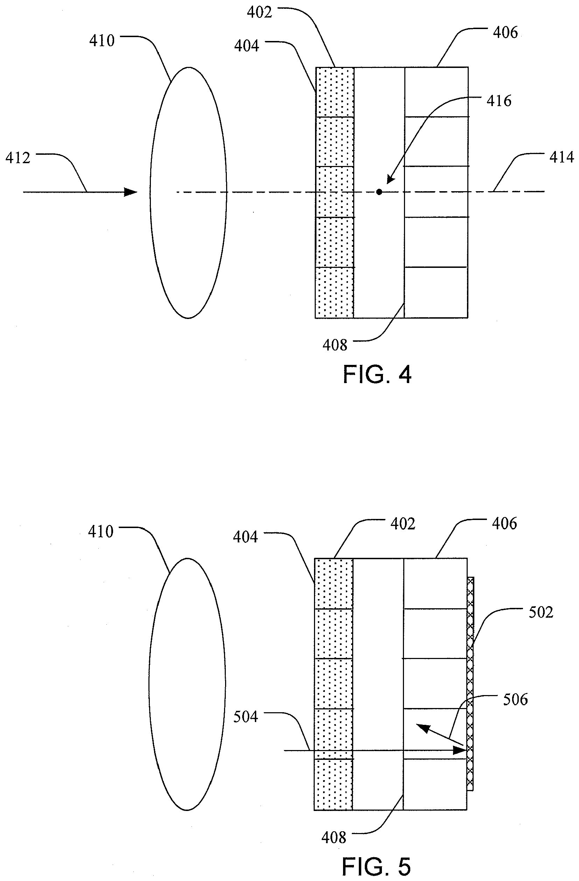

Turning to various physical configurations of the system, in one aspect an imaging system capable of deriving three dimensional information from a three dimensional subject can, as is shown in FIG. 4, include a first imager array 402 having a first light incident surface 404 and a second imager array 406 having a second light incident surface 408. The second imager array 406 is coupled to the first imager array 402 at a surface that is opposite the first light incident surface 404. It is noted that in one aspect the first imager array can be physically coupled to the second imager array. In another aspect, the first imager array can be optically coupled to the second imager array. Furthermore, the second light incident surface 408 is oriented toward the first imager array 402 and at least substantially uniformly spaced at a distance of from about 2 microns to about 150 microns from the first light incident surface. The system can additionally include a system lens 410 positioned to direct incident light 412 along an optical pathway 414 onto the first light incident surface 404. In some aspects, the system lens 410 can have a focal point 416 located in between the first light incident surface 404 and the second light incident surface 408, and/or in between the first imager array 402 and the second imager array 406. The first imager array 402 is operable to detect a first portion of the light passing along the optical pathway 414 and to pass through a second portion of the light, and the second imager array 406 is operable to detect at least a part of the second portion of light. In some aspects the first portion of light and the second portion of light have at least one wavelength of from about 500 nm to about 1100 nm. In another aspect, the first portion of light and the second portion of light have at least one wavelength of from about 750 nm to about 1100 nm. In another aspect, the second portion of light includes at least substantially all wavelengths of light of from about 750 nm to about 1100 nm. In a further aspect, the first portion of light and the second portion of light have a center wavelength frequency between about 500 nm and about 1100 nm. In another aspect, the first portion of light and the second portion of light have a center wavelength frequency between about 750 nm and about 1100 nm.

The wavelengths of light utilized by the stacked imager system can vary depending on, among other things, the design of the system and the intended application. In some aspects the same or substantially the same light wavelengths can be utilized by both the first imager array and the second imager array to derive distance and/or three dimensional information from the subject. In other aspects, different light wavelengths can be utilized by the first imager array than by the second imager array. While in many aspects IR light wavelengths are used to calculate three dimensional information about a subject, in some aspects visible light can be used to make such calculations. For example, assuming crystalline silicon imagers are utilized for the imager arrays, light in the visible spectrum of from about 500 nm to about 700 nm can be used, provided the first imaging array is sufficiently thin to allow a second portion of the visible light to pass there through. Furthermore, in some cases different wavelengths of light can be utilized differently in the system. For example, infrared light can be used by both the first imager array and the second imager array to generate a three dimensional representation or three dimensional image, while visible light can be captured by the first imager array in order to generate a visible image of the subject. When the two representations are combined, a resulting three dimensional visible image of the subject can be achieved.

In another aspect, system can include an active illumination source, a first imager capable of detecting visible and infrared (IR) light and a second imager capable of detecting IR light. The system can further include an active illumination source capable of emitting IR light. The active illumination source, first imager and the second imager can pulsed at the same frequency such that the pulsed IR light is detected during the pulse window. When the IR illumination source is off (i.e. in between pulses), the first image sensor is detecting and reading out visible light data.

Additionally, in some aspects the one or more of the first and second imager arrays can include light filters that are capable of filtering out specific wavelengths of light or ranges of wavelengths of light. As such, light having a certain wavelength or wavelength range can be concentrated by a structure such as a system lens on a specific imager array or even a portion of an imager array. In one aspect, an IR cut filter (moveable) or notch filter can be employed in front one or more pixels of the first imager array. Such a filter can pass infrared light that will be used in range or distance determination and filter out light in the visible range. In some cases a long-pass filter can pass both infrared and visible red light. Similarly, a long-pass filter can be utilized that passes green, red, and infrared light. In other aspects, a band-pass filter can be used that passes visible light and specific wavelengths of IR light, such as, for example, 850 nm, 940 nm, and/or 1064 nm light, while blocking all other wavelengths.

It is additionally contemplated that in one aspect the system can include a focusing system for altering the focal plane(s) of the imaging system. While various techniques are contemplated, in one aspect the distance of the first imager array from the second imager array can be varied by, for example, piezoelectric materials.

In some aspects, the system can additionally include an active light emitter configured to emit active light radiation at least substantially toward the subject. While any light can be utilized as an active light source, in one aspect the active light source can emit light having a center wavelength in the infrared range. In another aspect, the emitted light can have a center wavelength of from about 750 nm to about 1100 nm. In yet another aspect, the active light radiation can have a center frequency selected from 850 nm, 940 nm, 1064 nm, or a combination thereof.

As has been described, in some aspects the system can include a computational module that is operable to calculate distance data from the imaging system to the three dimensional subject using first image data collected by the first imager array from the first portion of light and second image data collected by the second imager array from the second portion of light. Computational modules are well known, and can include various processing units, data storage, memory, I/O functionality, and the like. In one aspect the computation module is capable of generating a three dimensional representation of the subject from the distance data. In another aspect the computational module can generate a three dimensional image from the data derived from the first imager array and the second imager array. In other aspects, the imaging system can be incorporated into a computing system operable to alter computation based on variations in distance data derived from movements of a subject. For example, in the case of a human subject, motions made by the subject can be captured by the imaging system and used by the computing system to alter the computation of the computing system. In the case of non-living subjects, computation of the computing system can be varied according to the motion of an oncoming vehicle or other moving subject.

Returning to the imager system configuration, in one aspect the distance from the first light incident surface to the second light incident surface is from about 1 microns to about 150 microns. In another aspect, aspect the distance from the first light incident surface to the second light incident surface is from about 10 microns to about 100 microns. In a further aspect, the distance from the first light incident surface to the second light incident surface is from about 1 micron to about 50 microns. Furthermore, each of the first and second imager array is made up of a plurality of pixels. The pixels can be architecturally configured as front-side illuminated pixels or back-side illuminated pixels. For example, in one aspect all of the first imager array pixels and the second imager array pixels can be front-side illuminated pixels. In another aspect, all of the first imager array pixels can be front-side illuminated and all of the second imager array pixels can be backside illuminated pixels. Additionally, it is contemplated that in some aspects either of the first or second imager arrays can be front-side illuminated while the other imager array can be backside illuminated.

Furthermore, as is shown in FIG. 5, in some aspects a system can include a texture region 502 coupled to the second imager array 406 on a side opposite the first imager array 402. In this case, the textured region 502 is positioned to redirect light passing through the second imager array 406 back into the second imager array 406. The light passing through the second imager array is shown at 504, and the light redirected back into the imager array is shown at 506. It is noted that the textured region 502 can be formed across all or substantially all of the back surface of the second imager array 406, or the textured region 502 can be formed on a portion thereof. Additionally, in some aspects the textured region can be formed at the level of the pixels that make up the imager array, and as such, can be formed on a portion of the pixel surface, substantially all of the pixel surface, or all of the pixel surface. Also, it is noted that callout numbers used in FIG. 5 from previous figures denote the same or similar structures as the previous figure. Furthermore, in some aspects a textured region is explicitly disclaimed from being applied to the first imager array, while in other aspects such a textured region can be utilized.

The textured region can function to diffuse electromagnetic radiation, to redirect electromagnetic radiation, and/or to absorb electromagnetic radiation, thus increasing the efficiency of the second imager array. The textured region can include surface features to thus increase the optical path length of the second imager array. Such surface features can be micron-sized and/or nano-sized, and can be any shape or configurations. Non-limiting examples of such shapes and configurations include cones, pillars, pyramids, micolenses, quantum dots, inverted features, gratings, protrusions, and the like, including combinations thereof. Additionally, factors such as manipulating the feature sizes, dimensions, material type, dopant profiles, texture location, etc. can allow the diffusing region to be tunable for a specific wavelength or wavelength range. Thus in one aspect, tuning the device can allow specific wavelengths or ranges of wavelengths to be absorbed.

As has been described, textured regions according to aspects of the present disclosure can also allow an imager array to experience multiple passes of incident electromagnetic radiation within the device, particularly at longer wavelengths (i.e. infrared). Such internal reflection increases the optical path length to be greater than the thickness of the semiconductor. This increase in the optical path length increases the quantum efficiency of the device, leading to an improved signal to noise ratio.

The textured region can be formed by various techniques, including plasma etching, reactive ion etching, porous silicon etching, lasing, chemical etching (e.g. anisotropic etching, isotropic etching), nanoimprinting, material deposition, selective epitaxial growth, shallow trench isolation, and the like. One effective method of producing a textured region is through laser processing. Such laser processing allows discrete locations of the imager array or other substrate to be textured. A variety of techniques of laser processing to form a textured region are contemplated, and any technique capable of forming such a region should be considered to be within the present scope. Examples of such processing have been described in further detail in U.S. Patents 7,057,256, 7,354,792 and 7,442,629. Briefly, a surface of a substrate material is irradiated with laser radiation to form a textured or surface modified region.

The type of laser radiation used to surface modify a material can vary depending on the material and the intended modification. Any laser radiation known in the art can be used with the devices and methods of the present disclosure. There are a number of laser characteristics, however, that can affect the texturing process and/or the resulting product including, but not limited to the wavelength of the laser radiation, pulse width, pulse fluence, pulse frequency, polarization, laser propagation direction relative to the semiconductor material, etc. In one aspect, a laser can be configured to provide pulsatile lasing of a material. A short-pulsed laser is one capable of producing femtosecond, picosecond and/or nanosecond pulse durations. Laser pulses can have a central wavelength in a range of about from about 10 nm to about 8 $\mu$m, and more specifically from about 200 nm to about 1200 nm. The pulse width of the laser radiation can be in a range of from about tens of femtoseconds to about hundreds of nanoseconds. In one aspect, laser pulse widths can be in the range of from about 50 femtoseconds to about 50 picoseconds. In another aspect, laser pulse widths can be in the range of from about 50 picoseconds to 100 nanoseconds. In another aspect, laser pulse widths are in the range of from about 50 to 500 femtoseconds. In another aspect, laser pulse widths are in the range of from about 10 femtoseconds to about 500 picoseconds.

The number of laser pulses irradiating a target region can be in a range of from about 1 to about 2000. In one aspect, the number of laser pulses irradiating a target region can be from about 2 to about 1000. Further, the repetition rate or frequency of the pulses can be selected to be in a range of from about 10 Hz to about 10 $\mu$Hz, or in a range of from about 1 kHz to about 1 MHz, or in a range from about 10 Hz to about 1 kHz. Moreover, the fluence of each laser pulse can be in a range of from about 1 kJ/m$^2$ to about 20 kJ/m$^2$, or in a range of from about 3 kJ/m$^2$ to about 8 kJ/m$^2$.

In another aspect of the present disclosure, an imaging system can further include a reflector coupled to the second imager array on a side opposite the first imager array. The reflector can be positioned to reflect light passing through the second imager array back into the second imager array. Numerous reflector materials are contemplated, and can include any material or composite of materials that can function to reflect light. Non-limiting examples of such materials can include metals, metal alloys, ceramics, polymers, glass, quartz, Bragg-type reflectors, and the like.

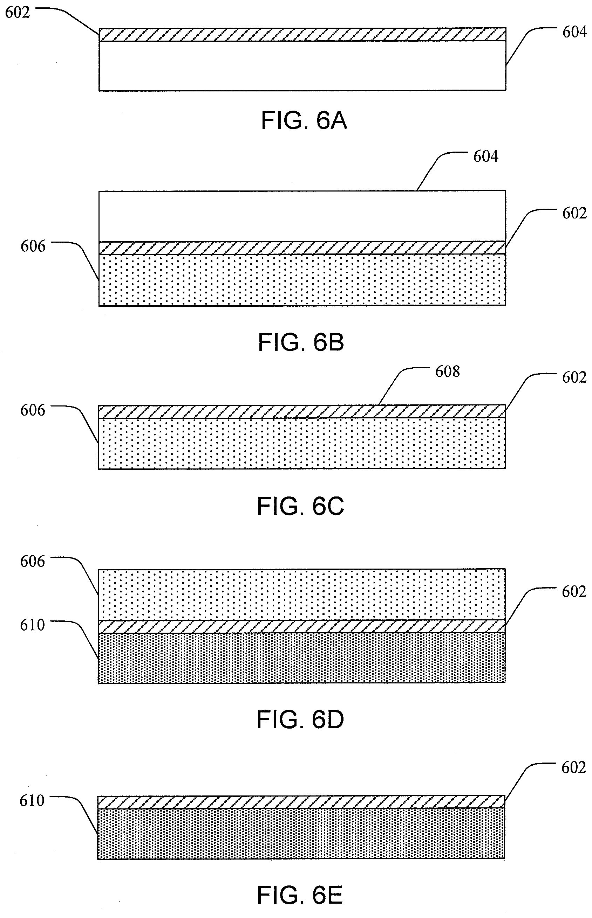

FIGs. 6A-E show various steps in the non-limiting manufacture of a stacked imager structure according to one aspect of the present disclosure. As is shown in FIG. 6A, for example, first imager array 602 is formed on the front side of a semiconductor layer 604. The first imager array 602 can include any form of imager array that can be incorporated into an imager system, and any such device is considered to be within the present scope. A variety of semiconductor materials are contemplated for use as the semiconductor layer of the devices and methods according to aspects of the present disclosure. As such, any semiconductor material that can be used in a stacked imager device is considered to be within the present scope. Non-limiting examples of such semiconductor materials can include group IV materials, compounds and alloys comprised of materials from groups II and VI, compounds and alloys comprised of materials from groups III and V, and combinations thereof. More specifically, exemplary group IV materials can include silicon, carbon (e.g. diamond), germanium, and combinations thereof. Various exemplary combinations of group IV materials can include silicon carbide (SiC) and silicon germanium (SiGe). In one specific aspect, the semiconductor material can be silicon. In another specific aspect, the semiconductor layer can be a silicon wafer. The silicon wafer/material can be monocrystalline, multicrystalline, microcrystalline, amorphous, and the like. In one specific aspect, the silicon material can be a monocrystalline silicon wafer.

Turning to FIG. 6B, a carrier substrate (or handle) 606 can be bonded to the first imager array 602. Note that in FIG. 6B, the device has been flipped or rotated 180° as compared to FIG. 6A. The carrier substrate can include a variety of materials. Because in many aspects the carrier substrate 606 is a temporary substrate to be removed at a later processing step, the material can be chosen based on its usefulness as a temporary substrate. It can also be beneficial for the carrier substrate 606 to be capable of adequately holding the first imager array 602 during processing of the semiconductor layer 604 and yet be capable of easy removal. Non-limiting examples of potential carrier substrate materials can include glass, ceramics, semiconductors, and the like, including combinations thereof.

Various bonding techniques are contemplated for attaching the carrier substrate 606 to the first imager array 602, and any such bonding technique useful in making a stacked imager device is considered to be within the present scope. One such process can include a liquid UV curable adhesive process that utilizes solids acrylic adhesives designed for temporary bonding of semiconductor wafers to a glass carrier substrate. This technique provides a rigid, uniform support surface that minimizes stress on the wafer during the subsequent processing steps, resulting in less warpage, cracking, edge chipping and higher yields. Other exemplary methods can include bonding and detaching a temporary carrier used for handling a wafer during the fabrication of semiconductor devices, includes bonding the wafer onto the carrier through an adhesive layer. After detaching the carrier from the wafer, the first adhesive layer remaining on the wafer is removed. In another method, bonding at low or room temperature can include surface cleaning and activation by cleaning or etching, followed by polishing the surfaces to be bonded to a high degree of smoothness and planarity. Reactive ion etching or wet etching is used to slightly etch the surfaces being bonded. The etched surfaces may be rinsed in solutions such as ammonium hydroxide or ammonium fluoride to promote the formation of desired bonding species on the surfaces.

In one aspect, the first imager array 602 and the carrier substrate 606 can be bonded at room temperature and a thermal treatment can be applied to consolidate the bonding interface. The parameters of the consolidation annealing can be controlled to provide a bonding energy high enough for the heterostructure to withstand post- bonding conventional process steps (e.g. CMOS processing). In one specific aspect, the bonding technique can include various oxide-oxide, oxide-silicon, or metal-metal bonding methods.

Some bonding processes can achieve a bond strength of at least 1 J/m$^2$ at room temperature. For even higher bond strengths, a bake cycle at 100° - 300° C can be utilized. Some of these oxide-oxide bonding process have been described in U.S. Patent 7,871,898 and U.S. Patent 5,843, One method of direct bonding a silicon wafer onto an insulated wafer in order to obtain a stacked imager device is similar to the bonding of two silicon wafers together, with the exception that before bonding a thin thermal oxide layer (e.g. about 1 micron) is grown on one of the wafers.

Release of the carrier substrate from the device layer can vary depending on the attachment process. Acrylic adhesives, for example, can be released by exposure to UV light. More permanent bonds, such as silicon-oxide bonds may require the removal of the carrier substrate by mechanical grinding and/or chemical etching to expose the device layer.

Turning to FIG. 6C, the semiconductor layer 604 (FIG. 6B) is at least partially removed (e.g. polished and thinned) to expose the backside of the first imager array 602 or, in other words, to form a processed surface 608 at the backside of the first imager array 602. Thus, the resulting structure is comprised of the first substrate 606 coupled to the first imager array 602. At this point, any necessary or beneficial backside processing can be performed on the processed surface 608 of the first imager array 602. Such beneficial backside processing can include, without limitation, shallow or deep trench formation, via formation, annealing, implantation, and the like.

In one aspect, backside processing can also include exposing contact pads associated with the first imager array. By opening the backside of the device layer (i.e. at the processed surface), such electrical contacts can be exposed for bonding and providing electrical contact to subsequent structures, such as the second imager array (see below). Opening the backside can occur by any known technique, including the thinning and processing methods described. In one specific aspect, opening the backside can be accomplished via plasma etching.

Any technique useful for removing the semiconductor layer 604 is considered to be within the present scope. Non-limiting examples can include ion implantation/separation processes, laser ablation, laser splitting, CMP processing, dry etching, wet etching and the like, including combinations thereof. In one specific aspect, the semiconductor layer is removed by CMP techniques to expose the device layer 602.

Following removal or thinning of the semiconductor layer 604, a second imager array 610 is bonded to the backside of the first imager array 602, as is shown in FIG. 6D. Note that in FIG. 6D, the device has been flipped or rotated by 180° compared to FIG. 6C. Any bonding technique can be utilized to bond the second imager array 210 to the first imager array 202, as was described for the bonding of the first substrate 206 to the first imager array 202 (FIG. 6B), provided the process is compatible with both structures. It is noted that any spacing that exists between the first and second imager arrays can be filled with a light transparent material such as amorphous silicon, an oxide, nitride, or the like. In some aspects an air gap can be maintained between the first and second imager arrays. Such a gap can be filled with actual air, an inert gas, a vacuum, etc.

Additionally, it is noted that the first imager array and the second imager array can be electrically coupled to, and thus can function in conjunction with, one another. Such electrical coupling can be accomplished by vias formed through the processed surface that connect the two imager arrays.

Turning to FIG. 6E, in some aspects the carrier substrate 606 (FIG. 6D) can be removed from the first imager array 602 following bonding of the second imager array 610. Thus, the resulting stacked imager structure shown in FIG. 6E includes a second imager array 610 bonded to a first imager array 602.

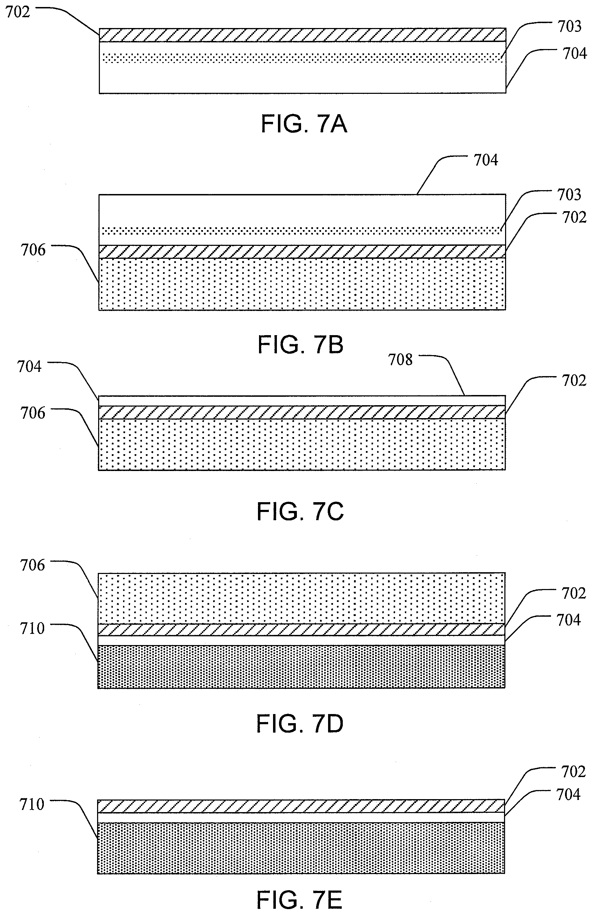

In another aspect, FIGs. 7A-E show various steps in the manufacture of a stacked imager device using an embedded oxide layer to facilitate thinning and creating a space between the imager arrays. As is shown in FIG. 7A, for example, first imager array 702 can be formed on the front side of a semiconductor layer 704. The first imager array 702 can include any form of imager array that can be incorporated into a stacked imager device, as has been described. A thin oxide layer 703 can be embedded within the semiconductor layer 704, either before or after the formation of the first imager array 702. The thin oxide layer can be of any shape and thickness useful for the particular device design. In some aspects, however, the thin oxide layer can be from about 4000 angstroms to about 1.5 microns thick. It is also noted that commercial SOI substrates can be used that are manufactured having such a thin oxide layer embedded.

Turning to FIG. 7B, a carrier substrate 706 can be bonded to the first imager array 702. Note that in FIG. 7B, the device has been flipped or rotated 180° as compared to FIG. 7A. The carrier substrate can include a variety of materials. Because in most aspects the carrier substrate 706 is a temporary substrate to be removed at a later processing step, the material can be chosen based on its usefulness as a temporary substrate.

Turning to FIG. 7C, the semiconductor layer 704 (FIG. 7B) is at least partially removed to form a processed surface 708 near the backside of the first imager array 702. In one aspect, the semiconductor layer 704 can be removed at least to the thin oxide layer 703. In some aspects at least a portion of the thin oxide layer can remain, while in other aspects the thin oxide layer can be completely removed from the semiconductor layer. This material can be removed by any known method, such as, for example, laser splitting, polishing, thinning, etching, lapping or grinding, CMP processing, or a combination thereof.

Thus, the resulting structure is comprised of the carrier substrate 706 coupled to the first imager array 702. A portion of the semiconductor layer 704 can remain coupled to the first imager array 702 opposite the carrier substrate 706. At this point, any necessary or beneficial backside processing can be performed on the first imager array 702. In one specific aspect, processing the semiconductor layer on the backside can include implant and/or laser anneal conditions to reduce surface defects.

Following thinning of the semiconductor layer 704, a second imager array 710 can be bonded to the semiconductor layer 704 at backside of the first imager array 702, as is shown in FIG. 7D. Note that in FIG. 7D, the device has been flipped or rotated 180° compared to FIG. 7C. Any bonding technique can be utilized to bond the second imager array 710 to the semiconductor layer 704, as has been described.

Turning to FIG. 7E, in some aspects the carrier substrate 706 (FIG. 7D) can be removed from the first imager array 702 following bonding of the second imager array 710. Thus, the resulting stacked imager structure shown in FIG. 7E includes a second imager array 710 bonded to the semiconductor layer 704, which is bonded to the first imager array 702. It is noted that the distance between the imagers can be varied during manufacture by varying the thickness of the semiconductor layer 704 that remains and is bonded between the imager arrays.

The present disclosure additionally provides methods of determining distance to a subject. In one aspect, for example, such a method can include focusing incident light along an optical pathway onto a first light incident surface of a first imaging array, where the first imaging array captures a first portion of the light having at least one wavelength of from about 500 nm to about 1100 nm to generate a first data set and passes through a second portion of the light along the optical pathway. The method can also include receiving the second portion of the light onto a second light incident surface of a second imaging array, where the second imaging array captures the second portion of the light having at least one wavelength of from about 500 nm to about 1100 nm to generate a second data set. Furthermore, the distance to the subject can be derived from variations between the first data set and the second data set. In another aspect the method can also include redirecting at least part of the second portion of the light that passes through the second imaging array back into the second imaging array.

In another aspect, the present disclosure provides an imaging system capable of deriving three dimensional information from a three dimensional subject. Such a system can include an active illumination source capable of emitting pulsed infrared light, a first imager capable of detecting visible and infrared light, and a second imager capable of detecting infrared light. The active illumination source, first imager, and the second imager can be pulsed at a frequency and duty cycle such that the pulsed infrared light is detected by the first imager and the second imager when the active illumination is on. In one aspect the first imager is operable to detect visible light when the active illumination source is in an off state.

It is to be understood that the above-described arrangements are only illustrative of the application of the principles of the present disclosure. Numerous modifications and alternative arrangements may be devised by those skilled in the art without departing from the scope of the present invention as defined in the appended claims.

## Claims

1. An imaging system for deriving three dimensional information from a three dimensional subject, comprising:

   a first imager array (402) having a first light incident surface (404);
   a second imager array (406) having a second light incident surface (408), the second imager array (406) being coupled to the first imager array (402) at a surface that is opposite the first light incident surface (404), the second light incident surface (408) being oriented toward the first imager array (402) and at least substantially uniformly spaced at a distance of from 2 microns to 150 microns from the first light incident surface (404);
   a system lens (410) positioned to direct incident light along an optical pathway (414) onto the first light incident surface (404), wherein the first imager array (402) is operable to detect a first portion of the light passing along the optical pathway (414) and to pass through a second portion of the light, wherein the second imager array (406) is operable to detect at least a part of the second portion of light, and wherein the first portion of light and the second portion of light have at least one wavelength of from 500 nm to 1100 nm; and

a computation module configured to receive first image data collected by the first imager array (402) from the first portion of light and second image data collected by the second imager array (406) from the second portion of light, wherein the computation module is operable to calculate distance data from the imaging system to the three dimensional subject by:

calculating the effective feature radii of a defocussed image from the total volume of the image pixel values using equations:

$$r1 = sqrt(sum(pixel\_value\_imagel)/(pi*max(pixel\_value\_image1)$$

$$r2 = sqrt(sum(pixel\_value\_image2)/(pi*max(pixel\_value\_image2)$$

where r1 and r2 are the image radii of the first image pattern and the second image pattern; calculating the smallest image size location from the first image data based on the feature radii of the first image pattern and the second image pattern using equation:

$$d = r1*t/(r1+r2)$$

where d is the distance from the first image and t is the separation between the first light incident surface (404) and second light incident surface (408); and calculating the distance from the imaging system to the three dimensional subject using lens imaging equation:

$$D = 1/(1/f - 1/(s+d))$$

where D is the distance from the three dimensional subject to the system lens' principle plane, f is the focal length of the system lens (410), s is the distance from system lens' principle plane to the first image and d is the distance from the first image to the smallest image location.

2. The imaging system of claim 1, wherein the first portion of light and the second portion of light have at least one wavelength of from 750 nm to 1100 nm.

3. The imaging system of claim 1, wherein the distance between the first light incident surface (404) and the second light incident surface (408) is from 10 microns to 100 microns.

4. The imaging system of claim 1, wherein the first imager array (402) is operable to capture a visible light image.

5. The imaging system of claim 1, wherein the first imager array includes a plurality of pixels architecturally configured as front-side illuminated pixels.

6. The imaging system of claim 1, further comprising a textured region (502) coupled to the second imager array (406) on a side opposite the first imager array (402), wherein the textured region (502) is positioned to redirect light passing through the second imager array (406) back into the second imager array (406); or further comprising a reflector coupled to the second imager array (406) on a side opposite the first imager array (402), wherein the reflector is positioned to reflect light passing through the second imager array (406) back into the second imager array (406).

7. The imaging system of claim 1, wherein the system lens (410) has a focal point located in between the first light incident surface (404) and the second light incident surface (408).

8. The imaging system of claim 2, wherein the imaging system further comprises an active light emitter configured to emit active light radiation at least substantially toward the three dimensional subject and having a center wavelength of from 750 nm to 1100 nm.

9. The imaging system of claim 8, wherein the active light radiation has a center frequency selected from the group consisting of 850 nm, 940 nm, and 1064 nm.

10. The imaging system of claim 8, wherein the active light emitter is capable of emitting pulsed light, and wherein the active light emitter, the first imager array (402), and the second imager array (406) are pulsed at a frequency and duty cycle such that the pulsed infrared light is detected by the first imager array (402) and the second imager array (406) when the active light emitter is on.

11. The imaging system of claim 10, wherein the first imager array (402) is operable to detect visible light when the active light emitter is in an off state.

12. The imaging system of claim 1, wherein the imaging system is incorporated into a computing system operable to alter computation based on variations in distance data derived from movements of a subject.

13. The imaging system of claim 1, wherein the first imager array (402) includes a plurality of pixels architecturally configured as front-side illuminated pixels and wherein the second imager array (406) includes a plurality of pixels architecturally configured as front-side illuminated pixels or back-side illuminated pixels.


**Patentansprüche**

1. Bildgebungssystem zum Ableiten dreidimensionaler Informationen aus einem dreidimensionalen Gegenstand, umfassend:

eine erste Bildgeberanordnung (402) mit einer ersten Lichteinfallsoberfläche (404);
eine zweite Bildgeberanordnung (406) mit einer zweiten Lichteinfallsoberfläche (408), wobei die zweite Bildgeberanordnung (406) an die erste Bildgeberanordnung (402) an einer Oberfläche gekoppelt ist, die gegenüber der ersten Lichteinfallsoberfläche (404) ist, wobei die zweite Lichteinfallsoberfläche (408) zu der ersten Bildgeberanordnung (402) hin orientiert und mindestens im Wesentlichen gleichmäßig in einem Abstand von 2 Mikron bis 150 Mikron von der ersten Lichteinfallsoberfläche (404) beabstandet ist;
eine Systemlinse (410), die positioniert ist, um einfallendes Licht entlang eines optischen Wegs (414) auf die erste Lichteinfallsoberfläche (404) zu richten, worin die erste Bildgeberanordnung (402) betreibbar ist, um einen ersten Teil des entlang des optischen Wegs (414) verlaufenden Lichts zu erkennen und einen zweiten Teil des Lichts durchzulassen, worin die zweite Bildgeberanordnung (406) betreibbar ist, um mindestens einen Teil des zweiten Lichtteils zu erkennen, und worin der erste Lichtteil und der zweite Lichtteil mindestens eine Wellenlänge von 500 nm bis 1100 nm aufweisen; und
ein Berechnungsmodul, das konfiguriert ist, um von der ersten Bildgeberanordnung (402) aus dem ersten Lichtteil gesammelte erste Bilddaten und von der zweiten Bildgeberanordnung (406) aus dem zweiten Lichtteil gesammelte zweite Bilddaten entgegenzunehmen, worin das Berechnungsmodul betreibbar ist, um Abstandsdaten von dem Bildgebungssystem zu dem dreidimensionalen Gegenstand zu berechnen, durch:

Berechnen der effektiven Merkmalsradien eines defokussierten Bildes aus dem Gesamtvolumen der Bildpixelwerte mittels Gleichungen:

$$r1 = \text{Quadratwurzel}(\text{Summe}(\text{Pixel\_Wert\_Bild1})/(pi*\max(\text{Pixel\_Wert\_Bild1})$$

$$r2 = \text{Quadratwurzel}(\text{Summe}(\text{Pixel\_Wert\_Bild2})/(pi*\max(\text{Pixel\_Wert\_Bild2})$$

wobei r1 und r2 die Bildradien des ersten Bildmusters und des zweiten Bildmusters sind;
Berechnen der kleinsten Bildgrößenposition aus den ersten Bilddaten auf Basis der Merkmalsradien des ersten Bildmusters und des zweiten Bildmusters mittels Gleichung:

$$d = r1*t/(r1 + r2)$$

wobei d der Abstand von dem ersten Bild ist und t die Trennung zwischen der ersten Lichteinfallsoberfläche (404) und zweiten Lichteinfallsoberfläche (408) ist; und

Berechnen des Abstands von dem Bildgebungssystem zu dem dreidimensionalen Gegenstand mittels Linsenbildgebungsgleichung:

$$D = 1/(1/f - 1/(s+d))$$

wobei D der Abstand von dem dreidimensionalen Gegenstand zu der Hauptebene der Systemlinse ist, f die Brennweite der Systemlinse (410) ist, s der Abstand von der Hauptebene der Systemlinse zu dem ersten Bild ist und d der Abstand von dem ersten Bild zu der kleinsten Bildposition ist.

2. Bildgebungssystem nach Anspruch 1, worin der erste Lichtteil und der zweite Lichtteil mindestens eine Wellenlänge von 750 nm bis 1100 nm aufweisen.

3. Bildgebungssystem nach Anspruch 1, worin der Abstand zwischen der ersten Lichteinfallsoberfläche (404) und der zweiten Lichteinfallsoberfläche (408) von 10 Mikron bis 100 Mikron beträgt.

4. Bildgebungssystem nach Anspruch 1, worin die erste Bildgeberanordnung (402) betreibbar ist, um ein Bild des sichtbaren Lichts zu erfassen.

5. Bildgebungssystem nach Anspruch 1, worin die erste Bildgeberanordnung eine Mehrzahl von Pixeln beinhaltet, die architektonisch als vorderseitig beleuchtete Pixel konfiguriert sind.

6. Bildgebungssystem nach Anspruch 1, ferner umfassend eine texturierte Region (502), die an die zweite Bildgeberanordnung (406) auf einer Seite gegenüber der ersten Bildgeberanordnung (402) gekoppelt ist, worin die texturierte Region (502) positioniert ist, um durch die zweite Bildgeberanordnung (406) verlaufendes Licht zurück in die zweite Bildgeberanordnung (406) umzuleiten; oder ferner umfassend einen Reflektor, der an die zweite Bildgeberanordnung (406) auf einer Seite gegenüber der ersten Bildgeberanordnung (402) gekoppelt ist, worin der Reflektor positioniert ist, um durch die zweite Bildgeberanordnung (406) verlaufendes Licht zurück in die zweite Bildgeberanordnung (406) zu reflektieren.

7. Bildgebungssystem nach Anspruch 1, worin die Systemlinse (410) einen Brennpunkt aufweist, der sich zwischen der ersten Lichteinfallsoberfläche (404) und der zweiten Lichteinfallsoberfläche (408) befindet.

8. Bildgebungssystem nach Anspruch 2, worin das Bildgebungssystem ferner einen aktiven Lichtemitter umfasst, der konfiguriert ist, um aktive Lichtstrahlung mindestens im Wesentlichen zu dem dreidimensionalen Gegenstand hin und mit einer Mittenwellenlänge von 750 nm bis 1100 nm auszustrahlen.

9. Bildgebungssystem nach Anspruch 8, worin die aktive Lichtstrahlung eine Mittenfrequenz aufweist, die ausgewählt ist aus der Gruppe bestehend aus 850 nm, 940 nm und 1064 nm.

10. Bildgebungssystem nach Anspruch 8, worin der aktive Lichtemitter fähig ist, gepulstes Licht auszustrahlen, und worin der aktive Lichtemitter, die erste Bildgeberanordnung (402) und die zweite Bildgeberanordnung (406) mit einer Frequenz und einem Arbeitszyklus derart gepulst sind, dass das gepulste Infrarotlicht von der ersten Bildgeberanordnung (402) und der zweiten Bildgeberanordnung (406) bei eingeschaltetem aktivem Lichtemitter erkannt wird.

11. Bildgebungssystem nach Anspruch 10, worin die erste Bildgeberanordnung (402) betreibbar ist, um sichtbares Licht zu erkennen, wenn der aktive Lichtemitter in einem "Aus"-Zustand ist.

12. Bildgebungssystem nach Anspruch 1, worin das Bildgebungssystem in ein Rechnersystem einbezogen ist, das betreibbar ist, um Berechnung auf Basis von Variationen der aus Bewegungen eines Gegenstands abgeleiteten Abstandsdaten zu ändern.

13. Bildgebungssystem nach Anspruch 1, worin die erste Bildgeberanordnung (402) eine Mehrzahl von Pixeln beinhaltet, die architektonisch als vorderseitig beleuchtete Pixel konfiguriert sind, und worin die zweite Bildgeberanordnung (406) eine Mehrzahl von Pixeln beinhaltet, die architektonisch als vorderseitig beleuchtete Pixel oder rückseitig beleuchtete Pixel konfiguriert sind.

**Revendications**

1. Système d'imagerie permettant de dériver des informations tridimensionnelles à partir d'un sujet tridimensionnel, comprenant :

   un premier réseau imageur (402) ayant une première surface d'incidence de lumière (404) ;
   un deuxième réseau imageur (406) ayant une deuxième surface d'incidence de lumière (408), le deuxième réseau imageur (406) étant couplé au premier réseau imageur (402) au niveau d'une surface qui est opposée à la première surface d'incidence de lumière (404), la deuxième surface d'incidence de lumière (408) étant orientée vers le premier réseau imageur (402) et au moins espacée sensiblement uniformément d'une distance comprise entre 2 microns et 150 microns de la première surface d'incidence de lumière (404) ;
   une lentille du système (410) positionnée pour diriger la lumière d'incidence le long d'un trajet optique (414) sur la première surface d'incidence de lumière (404),
   dans lequel le premier réseau imageur (402) peut être utilisé pour détecter une première partie de la lumière passant le long du trajet optique (414) et pour passer à travers une deuxième partie de la lumière,
   dans lequel le deuxième réseau imageur (406) peut être utilisé pour détecter au moins une partie de la deuxième partie de la lumière, et dans lequel la première partie de la lumière et la deuxième partie de la lumière ont une ou plusieurs longueurs d'onde comprises entre 500 nm et 1100 nm ; et
   un module de calcul configuré pour recevoir des premières données d'image collectées par le premier réseau imageur (402) dans la première partie de la lumière et des deuxièmes données d'image collectées par le deuxième réseau imageur (406) dans la deuxième partie de la lumière,
   dans lequel le module de calcul peut être utilisé pour calculer des données de distance du système d'imagerie au sujet tridimensionnel comme suit :

   calculer les rayons caractéristiques efficaces d'une image défocalisée à partir du volume total des valeurs de pixel d'image en utilisant les équations :

   $$r1 = sqrt(sum(pixel\_value\_imagel)/(pi*max(pixel\_value\_image1)$$

   $$r2 = sqrt(sum(pixel\_value\_image2)/(pi*max(pixel\_value\_image2)$$

   où r1 et r2 sont les rayons d'image du premier motif d'image et du deuxième motif d'image ;
   calculer l'emplacement de la dimension d'image la plus petite à partir des premières données d'image sur la base des rayons caractéristiques du premier motif d'image et du deuxième motif d'image en utilisant l'équation :

   $$d = r1*t/(r1 +r2)$$

   où d est la distance de la première image et t est la séparation entre la première surface d'incidence de lumière (404) et la deuxième surface d'incidence de lumière (408) ; et
   calculer la distance du système d'imagerie au sujet tridimensionnel en utilisant une équation d'imagerie à lentille :

   $$D = 1/(1/f-1/(s+d))$$

   où D est la distance du sujet tridimensionnel au plan principal de la lentille du système, f est la longueur focale de la lentille du système (410), s est la distance de plan principal de la lentille du système à la première image et d est la distance de la première image à l'emplacement d'image la plus petite.

2. Système d'imagerie selon la revendication 1, dans lequel la première partie de la lumière et la deuxième partie de la lumière ont une ou plusieurs longueurs d'onde comprises entre 750 nm et 1100 nm.

3. Système d'imagerie selon la revendication 1, dans lequel la distance entre la première surface d'incidence de lumière (404) et la deuxième surface d'incidence de lumière (408) est comprise entre 10 microns et 100 microns.

4. Système d'imagerie selon la revendication 1, dans lequel le premier réseau imageur (402) peut être utilisé pour capturer une image de lumière visible.

5. Système d'imagerie selon la revendication 1, dans lequel le premier réseau imageur inclut une pluralité de pixels configuré architecturalement sous forme de pixels éclairés par la face avant.

6. Système d'imagerie selon la revendication 1, comprenant en outre une région texturée (502) couplée au deuxième réseau imageur (406) sur un côté opposé au premier réseau imageur (402), dans lequel la région texturée (502) est positionnée pour rediriger la lumière passant à travers le deuxième réseau imageur (406) dans le deuxième réseau imageur (406) ; ou comprenant en outre un réflecteur couplé au deuxième réseau imageur (406) sur un côté opposé au premier réseau imageur (402), dans lequel le réflecteur est positionné pour réfléchir la lumière passant à travers le deuxième réseau imageur (406) dans le deuxième réseau imageur (406).

7. Système d'imagerie selon la revendication 1, dans lequel la lentille du système (410) a un point focal situé entre la première surface d'incidence de lumière (404) et la deuxième surface d'incidence de lumière (408).

8. Système d'imagerie selon la revendication 2, dans lequel le système d'imagerie comprend en outre un émetteur de lumière actif configuré pour émettre un rayonnement lumineux actif au moins sensiblement vers le sujet tridimensionnel et ayant une longueur d'onde centrale comprise entre 750 nm et 1100 nm.

9. Système d'imagerie selon la revendication 8, dans lequel le rayonnement lumineux actif a une fréquence centrale sélectionnée dans le groupe constitué de 850 nm, 940 nm et 1064 nm.

10. Système d'imagerie selon la revendication 8, dans lequel l'émetteur de lumière actif est capable d'émettre une lumière pulsée, et dans lequel l'émetteur de lumière actif, le premier réseau imageur (402) et le deuxième réseau imageur (406) sont puisés à une fréquence et un cycle d'utilisation tels que la lumière infrarouge puisée est détectée par le premier réseau imageur (402) et le deuxième réseau imageur (406) quand l'émetteur de lumière actif est activé.

11. Système d'imagerie selon la revendication 10, dans lequel le premier réseau imageur (402) peut être utilisé pour détecter la lumière visible quand l'émetteur de lumière actif est dans un état désactivé.

12. Système d'imagerie selon la revendication 1, dans lequel le système d'imagerie est incorporé dans un système informatique pouvant être utilisé pour modifier le calcul sur la base de variations dans des données de distance dérivées des mouvements d'un sujet.

13. Système d'imagerie selon la revendication 1, dans lequel le premier réseau imageur (402) inclut une pluralité de pixels configurés architecturalement sous forme de pixels éclairés par la face avant et dans lequel le deuxième réseau imageur (406) inclut une pluralité de pixels configurés architecturalement sous forme de pixels éclairés par la face avant ou de pixels éclairés par la face arrière.

FIG. 1

FIG. 2

FIG. 3A

FIG. 3B

FIG. 3C

FIG. 4

FIG. 5

602

604

**FIG. 6A**

604

606

602

**FIG. 6B**

608

602

606

**FIG. 6C**

606

602

610

**FIG. 6D**

602

610

**FIG. 6E**

702
703
704

FIG. 7A

704
703
702
706

FIG. 7B

704
708
702
706

FIG. 7C

706
702
704
710

FIG. 7D

702
704
710

FIG. 7E

**EP 2 974 302 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2012174752 A1
- US 7057256 B
- US 7354792 B
- US 7442629 B
- US 7871898 B
- US 5843 A